## Europäisches Patentamt

## European Patent Office

## Office européen des brevets

(19)

(11) Veröffentlichungsnummer: **0 377 854**

**A1**

(12) # EUROPÄISCHE PATENTANMELDUNG

(21) Anmeldenummer: **89123200.1**

(22) Anmeldetag: **15.12.89**

(51) Int. Cl.5: **G01R 31/34, G06F 15/20**

(30) Priorität: 15.12.88 CH 4643/88
18.12.88 CH 4644/88
02.03.89 CH 763/89
21.04.89 CH 1523/89
15.09.89 DE 3930898

(43) Veröffentlichungstag der Anmeldung:
**18.07.90 Patentblatt 90/29**

(84) Benannte Vertragsstaaten:
**CH DE ES FR GB IT LI NL SE**

(71) Anmelder: **PAPST-MOTOREN GMBH & CO. KG**
**Karl-Maier-Strasse 1**
**D-7742 St. Georgen(DE)**

(72) Erfinder: **Amrhein, Wolfgang, Dr.-Ing.**
**Moos**
**CH-8848 Trachslau(CH)**

(74) Vertreter: **Eisenführ, Speiser & Strasse**
**Martinistrasse 24**
**D-2800 Bremen 1(DE)**

(54) **Mess- und Prüfstand für elektromechanische Wandler.**

(57) Die Erfindung betrifft einen Meß- und Prüfstand für mechanische und elektromechanische Bauteile, insbesondere Wandler, mit einer programmierbaren Strom- und/oder Spannungsquelle (20, 30; 5 - 7) zur Darstellung bzw. Einprägung beliebig definierbarer Kurvenformen, die zeit- oder positionsabhängig aus einem Funktionsspeicher (30) abgerufen werden, für die Speisung des zu messenden bzw. das mechanische Bauteil antreibenden oder belastenden Wandlers (3).

Fig. 8

**EP 0 377 854 A1**

## Meß- und Prüfstand für elektromechanische Wandler

Die Erfindung betrifft einen Meß- und Prüfstand für mechanische, teilmechanische und elektromechanische Bauteile oder Baugruppen, mit verschiedenen Meßeinrichtungen zum Messen verschiedener Parameter und mindestens einer einstellbaren Strom- oder Spannungsquelle zur Speisung mindestens eines zu prüfenden und/oder antreibenden elektromechanischen Wandlers.

Zum Prüfen von elektromechanischen Wandlern, wie z.B. Elektromotoren und Generatoren, sind bereits Meß- und Prüfstände bekannt, in denen der zu prüfende Wandler über eine Kupplung mit einer Belastungs- oder Antriebseinheit gekuppelt ist, und bei denen variable Stromversorgungen sowie Meßeinrichtungen zum Messen der verschiedenen Parameter am zu prüfenden Wandler sowie an der Belastungs- oder Antriebseinheit vorgesehen sind. Außerdem ist es bekannt, die von den Meßwertaufnehmern ermittelten Meßwerte zu speichern, anzuzeigen oder auch in einer Datenverarbeitungseinheit zu verarbeiten.

Mit solchen Meß- und Prüfständen können zwar die einzelnen elektrischen Parameter des zu messenden Wandlers in Abhängigkeit von den Wandler treibenden Strom- oder Spannungsamplituden manuell gemessen werden; es ist jedoch sehr mühsam, den Einfluß bestimmter Kurvenformen des speisenden Stromes bzw. der speisenden Spannung auf die einzelnen Parameter des Wandlers zu untersuchen, z.B. die Abhängigkeit des Drehmomentverlaufs eines Elektromotors von der Kurvenform des speisenden Stromes bzw. der Spannung. Die bisherigen Variationsmöglichkeiten erschöpften sich darin, Gleichspannungen oder -ströme, sinusförmige Wechselspannungen oder -ströme oder rechteckförmige Signale anzulegen.

Der vorliegenden Erfindung liegt die Aufgabe zugrunde, einen Meß- und Prüfstand vorzuschlagen, mit dem automatische Prüfläufe bei gleichzeitiger Aufzeichnung der einzelnen Meßwerte möglich sind, ohne daß etwa auf manuellem Wege Einzelwerte punktweise eingegeben und gemessen werden müssen.

Diese Aufgabe wird durch einen Meß- und Prüfstand der eingangs genannten Art gelöst, der gekennzeichnet ist durch eine programmierbare Strom- und/oder Spannungsquelle zur Darstellung bzw. Einprägung beliebig definierbarer periodischer und/oder nichtperiodischer Kurvenformen elektrischer, magnetischer oder anderer physikalischer Größen für die Speisung des bzw. der Wandler, eine Einrichtung zur Durchführung von Meßläufen mit bestimmten, programmierbaren Kurvenformen der Strom- und/oder Spannungsquelle, und eine Einrichtung zum Auswerten bestimmter Parameter oder Kennlinien des Wandlers bei solchen Meßläufen und zum Abspeichern der dazugehörigen Meßwerte.

Das universelle, rechnergesteuerte Konzept des Prüfsystems eröffnet neue Einsatzbereich für Hersteller und Anwender von Antriebskomponenten und Antriebssystemen. Die Optimierung von mechanischen und elektromechanischen Produkten läßt sich volautomatisch und somit schneller, sicherer und kostensparender durchführen.

Die Hauptvorteile des elektronischen Prüfsystems sind universelle Anwendbarkeit und große Flexibilität in der Gestaltung der Funktionsabläufe. Die nachfolgende Übersicht zeigt eine Auswahl der verschiedenen Betriebs- und Einsatzbereiche des Systems:

- Prüfung verschiedenartiger Elektromotoren und mechanischer Komponenten, wie Getriebe, Lager Meßgeber etc.
- Generierung von freiprogrammierbaren Spannungs- oder Stromkurvenformen für die Ansteuerung der Prüflinge, Belastungseinrichtungen und Meßgeräte
- schnelle Meßdatenerfassung elektrischer, magnetischer, mechanischer oder anderer Größen
- freiprogrammierbare Datenanalyse, Datentransformation oder Datenkompression
- automatische Ermittlung der Leitungssteller-Kennwerte für den spezifizierten Betrieb der Motoren
- Berechnung von Stromkurven für Motorbetrieb mit stark reduzierten Drehmoment- oder Drehzahlschwankungen

Die Messungen und Untersuchungen laufen wahlweise manuell gesteuert oder vollautomatisch ab.

Das System eignet sich für den Einsatz in der Entwicklung, Produktion und Qualitätskontrolle.

Die Erfindung betrifft insbesondere einen Meß- und Prüfstand für den Betrieb und/oder die Messung von elektromechanischen Wandlern, insbesondere Elektromotoren. Ein solcher Prüfstand ist gemäß vorteilhafter Ausführungsformen gekennzeichnet durch eine oder mehrere der folgenden Einheiten:

- eine mit dem zu messenden Wandler gekuppelte, einstellbare Belastungs- oder Antriebseinheit,
- einen Kraft- bzw. Drehmomentaufnehmer an bzw. zwischen dem Wandler und der Belastungs- oder Antriebseinheit,
- einen mit dem Wandler direkt oder indirekt gekuppelten Positions- bzw. Drehwinkelgeber.

Hierbei kann die Kraft bzw. das Drehmoment zwischen dem Wandler und der Belastungs- oder Antriebseinheit vorzugsweise mittels Strommessung in der Belastungs-oder Antriebseinheit ermittelt werden.

Für den Fall, daß der Meß- und Prüfstand für den Betrieb und/oder die Messung von mechanischen oder teilmechanischen Bauteilen ausgelegt wird, so müssen diese durch einen elektromechanischen Wandler, insbesondere Elektromotor, angetrieben werden.

Die Programmierung der Kurvenformen der Strom- bzw. Spannungsquelle kann hierbei entweder durch spektrale Synthese von Harmonischen oder durch Synthese von digital definierten Augenblickswerten erfolgen, und zwar abhängig von der Zeit oder abhängig von dem Ausgangssignal eines Positions- bzw. Drehwinkelgebers.

Insbesondere zur Optimierung von elektromechanischen Wandlern bzw. deren Ansteuerschaltungen ist eine vorteilhafte Ausführungsform des erfindungsgemäßen Meß- und Prüfstandes dadurch gekennzeichnet, daß eine Steuereinrichtung vorgesehen ist, die einen oder mehrere Meßläufe für einen oder mehrere Einflüsse (z. B. elektromagnetische reluktante, permanentmagnetische und mechanische Komponente) durchführt, in denen die vom Wandler ausgeübte Kraft bzw. das Drehmoment für einzelne Positionen bzw. Drehwinkel gemessen und aufgezeichnet werden, daß eine Einrichtung vorgesehen ist, die manuell oder automatisch gesteuert die Optimierung der Kurvenform(en) der Strom- und/oder Spannungsquelle(n) für einen anzustrebenden Verlauf der ausgeübten Kraft bzw. des Drehmomentes nach frei definierbaren Optimierungskriterien vornimmt, und daß die zu den einzelnen Positionen bzw. Drehwinkeln gehörenden Daten der Kurvenform(en) abgespeichert bzw. angezeigt werden.

Auf diese Weise können durch den Meß- und Prüfstand die für den jeweiligen Zweck optimalen Kurvenformen von Ansteuerspannungen bzw. -strömen für den elek tromechanischen Wandler ermittelt und abgespeichert werden. Vorzugsweise ist eine Einrichtung vorgesehen, mit der die abgespeicherten Daten der ermittelten Kurvenformen, gegebenenfalls nach Durchführung von Interpolationen und/oder manueller oder rechnergesteuerter Korrektur, aufbereitet und in Form von Datensätzen für die Verwendung in Ansteuerschaltungen von elektromechanischen Wandlern ausgebbar sind.

Um eine mechanische Ausrichtung des zu messenden elektromechanischen Wandlers zum programmierten Spannungs- oder Stromsignal überflüssig zu machen, ist vorzugsweise eine Einrichtung zum elektrischen Verschieben der programmierten und den Wandlern einzuprägenden Kurven bezüglich des Positions- bzw. Zeitmaßes vorgesehen.

Um das vom zu messenden (rotierenden) elektromechanischen Wandler auf die Belastungs- oder Antriebseinheit ausgeübte Drehmoment messen zu können, ist als Belastungs- oder Antriebseinheit vorzugsweise ein Glockenankermotor vorgesehen, der gleichzeitig (über Strommessung) als Drehmomentaufnehmer dient bzw. ein definiertes Drehmoment einprägt. Die Verwendung eines Glockenankermotors hat außerdem den Vorteil, daß keinerlei permanentmagnetische und reluktante Drehmomentschwankungen eingeführt werden. Es ist jedoch auch möglich, als Antriebs- oder Belastungseinheit einen Elektromotor zu verwenden, der eine nicht ideale Betriebscharakteristik aufweist, und dessen Charakteristik elektronisch durch Einprägung von bestimmten Strom- bzw. Spannungskurven zu verbessern. Außerdem sind auch rein passive Bremseinrichtungen verwendbar, wie z.B. Magnetpul verbremsen, Wirbelstrombremsen, Seilbremsen, Wasserkraftbremsen etc.

Der erfindungsgemäße Meß- und Prüfstand ist vorzugsweise derart aufgebaut, daß die verschiedenen Steuer-, Auswert- und Speicherfunktionen durch einen mit der entsprechenden Software ausgestatteten Rechner durchgeführt werden.

Die Prüfung und Messung der elektromagnetischen Wandler oder der mechanischen bzw. teilmechanischen Prüflinge kann aufgrund der universellen Rechnersteuerung auch nach deterministischen, statistischen Kriterien oder auch ereignisgesteuert erfolgen.

Weitere vorteilhafte Ausgestaltungen der Erfindung sind den Unteransprüchen zu entnehmen.

Die Erfindung wird nachfolgend anhand von Ausführungsbeispielen unter Bezug auf die beigefügten Zeichnungen näher erläutert.

Es zeigen:

Fig. 1 den prinzipiellen mechanischen Aufbau eines Meß- und Prüfstandes für elektrische Motoren mit Drehmoment- und Winkelaufnehmer;

Fig. 2 eine erste Ausführungsform des mechanischen Aufbaus eines Meß- und Prüfstandes ähnlich Fig. 1;

Fig. 3 eine zweite Ausführungsform des mechanischen Aufbaus;

Fig. 4 eine dritte Ausführungsform des mechanischen Aufbaus eines Meß- und Prüfstandes zum Messen und Prüfen mechanischer, teilmechanischer und elektromechanischer Bauteile oder Baugruppen;

Fig. 5 den Gesamtaufbau des Meß- und Prüfstandes in schematischer Darstellung;

Fig. 6 eine Ausführungsform des Hardware-Aufbaus des Meß- und Prüfstandes;

Fig. 7 die prinzipielle Funktionsweise des Kurvengenerators;

Fig. 8 eine erste Ausführungsform eines Steuer-und Regelsystems zur Ansteuerung von elektromechanischen Wandlern mit einem Kurvengenerator;

Fig. 9 eine zweite Ausführungsform ähnlich Fig. 8;

Fig. 10 die strukturelle Verknüpfung der einzelnen Programmpakete;

Fig. 11 eine Bildschirmdarstellung des Betriebsprogramms;

Fig. 12 eine Bildschirmdarstellung des Kurveneditors;

Fig. 13 eine Bildschirmdarstellung der Data-Aquisition-Unit;

Fig. 14 eine Bildschirmdarstellung des Frequenz-Editors im Absolutmodus;

Fig. 15 Darstellung einer Drehzahl-Drehmoment-Kennlinie bei der vollautomatischen Ermittlung von Motorkennlinien;

Fig. 16 Darstellung einer Strom-Drehmoment-Kennlinie bei der vollautomatischen Ermittlung von Motorkennlinien; und

Fig. 17 ein Beispiel für die vollautomatische Ermittlung von weiteren Motorkennlinien.

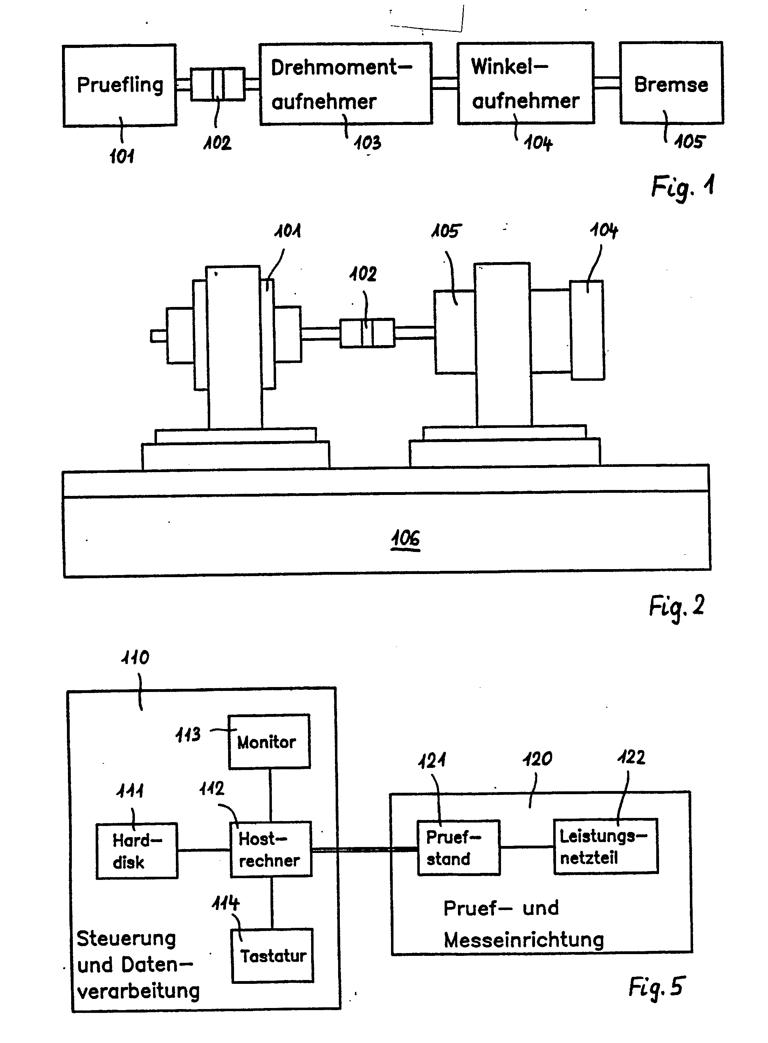

In Fig. 1 ist der prinzipielle mechanische Aufbau eines Meß- und Prüfstandes gezeigt, mit dem elektromechanische Wandler gemessen und geprüft werden können. Der elektromechanische Wandler 101 als Prüfling ist über eine Kupplung 102 sowie einen Drehmomentaufnehmer 103 mit einer Belastungs- oder Antriebseinheit 105 gekuppelt. Mit der Übertragungswelle ist eine Winkelaufnehmer 104 gekuppelt. Mit einem solchen Meß- und Prüfstand können z.B. Elektromotoren oder Generatoren gemessen und geprüft werden, wobei die Möglichkeiten nicht nur auf rotierende Maschinen beschränkt sind, sondern auch z.B. Linearmotoren einschließen. Das allgemeine Prinzip läßt sich auch auf andere elektromechanische Wandler übertragen, z.B. Schwingspulensysteme in Lautsprechern. In einem solchen Fall ist anstelle des Drehmomentaufnehmers 103 ein Kraftaufnehmer vorgesehen und anstelle des Winkelaufnehmers 104 ist eine Wegmeßeinrichtung vorgesehen.

Um den meßtechnischen Aufwand gering zu halten, ist es sinnvoll, nur die Grundgrößen wie z.B. Kraft, Drehmoment und Winkel, Strom und Spannung über Aufnehmer zu ermitteln und alle daraus ableitbaren Größen mittels eines Rechnersystems zu berechnen.

Die Kupplung zwischen dem elektromechanischen Wandler 101 und der Belastungs- oder Betätigungseinheit 105 ist sehr sorgfältig auszubilden, um keine zusätzlichen Störgrößen einzubringen. Hierbei sollte die Kupplung biegeelastisch, torsionssteif, trägheitsarm und umwuchtfrei sein. Bei vorhandenen Justage- und Ausrichteinrichtungen kann bei exakter Ausrichtung die Kupplung auch starr sein, womit natürlich eventuelle Schwingungsprobleme entfallen.

Als Winkelaufnehmer 104, bzw. allgemein als Weggeber, können solche nach dem optischen, kapazitiven, ohmschen oder induktiven Prinzip verwendet werden. Für das vorliegende Beispiel wird ein optisches Winkelgebersystem mit variabler Auflösung ausgewählt, das in die als Bremsmotor ausgebildete Belastungs-oder Antriebseinheit 105 integriert ist.

Als Drehmomentaufnehmer 103, bzw. Kraftaufnehmer, stehen mehrere Wege zur Verfügung. Zum einen kann das Drehmoment direkt an der rotierenden Welle gemessen werden oder das Rückstellmoment am Gehäuse des elektromechanischen Wandlers 101, oder zum anderen kann das Drehmoment indirekt über den Strom der Belastungs- oder Antriebseinheit 105 ermittelt werden. Wird als Belastungs- oder Antriebseinheit 105 ein Glockenankermotor als Bremsmotor verwendet, so besteht eine lineare Beziehung zwischen dem Motorstrom und dem Drehmoment, so daß auf diesem Wege durch Strommessung das Drehmoment verhältnismäßig genau bestimmt werden kann, ohne daß ein besonderer Drehmomentaufnehmer verwendet werden muß. Besteht keine lineare Beziehung, so kann dies durch eine vorgenommene Kennwertabspeicherung berücksichtigt werden.

Für die Belastungs- oder Antriebseinheit 105 gibt es mehrere Lösungen. Im Falle des Betriebes als Belastungseinheit sind passive Bremsen (z.B. Seilbremse, Magnetpulverbremse oder Wirbelstrombremse) oder aktive Bremsen (Elektromotoren bzw. Generatoren) möglich. Im vorliegenden Fall wurde ein - wie bereits erwähnt - Glockenankermotor als aktive Bremse ausgewählt, weil sich dieser besonders gut regeln läßt und ein kleines Massenträgheitsmoment bei großem Drehzahlbereich besitzt. Darüber hinaus kann ein solcher Glockenankermotor sowohl als Generator (Bremse) als auch als Motor dienen.

Unter Auswahl dieser Komponenten ergibt sich ein mechanischer Teil eines Meß- und Prüfstandes, wie er in Fig. 2 schematisch dargestellt ist. Auf einer Sockelplatte 106 sind sowohl der zu prüfende elektromechanische Wandler 101, z.B. ein Elektromotor, als auch die Belastungs- oder Antriebseinheit 105 entsprechend zueinander ausgerichtet montiert. Die Wellen der beiden Einheiten 101 und 105 sind durch eine Kupplung 102 miteinander gekuppelt. Die Belastungs- oder Antriebseinheit 105 ist gleichzeitig mit einem integrierten Winkelaufnehmer 104 ausgestattet.

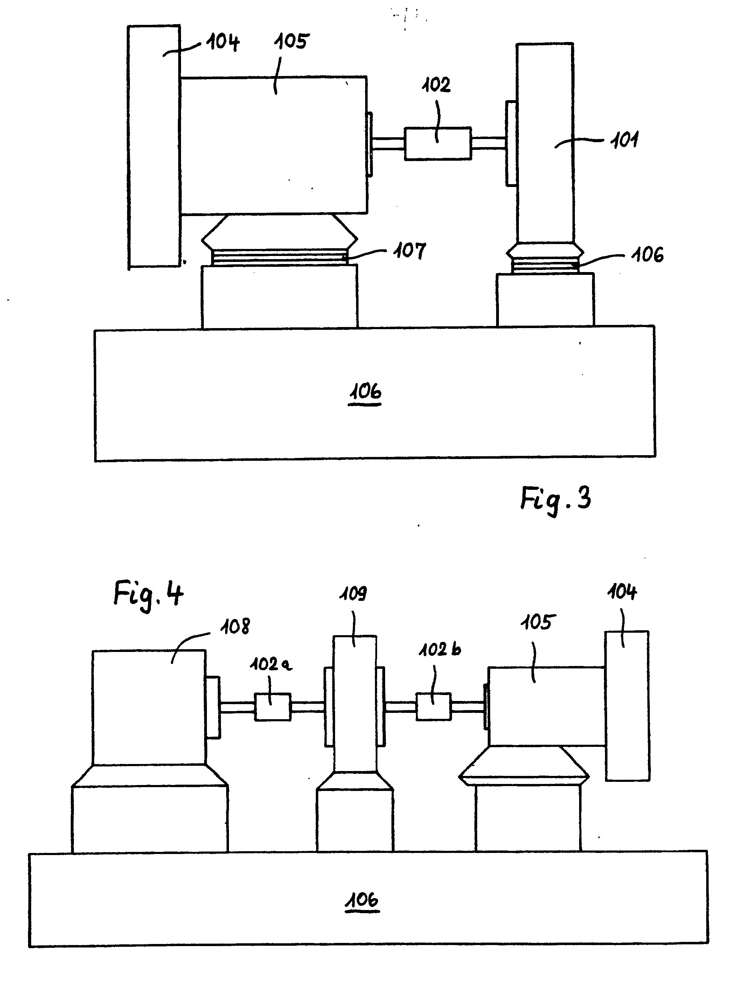

In Fig. 3 ist nun eine zweite Ausführungsform des mechanischen Aufbaus des Meß- und Prüfstandes für elektrische Motoren 101 gezeigt. Der Aufbau ist ähnlich dem nach Fig. 1 oder 2. Ein zu prüfender Elektromotor 101 ist auf einer Sockelplatte 106 über eine entsprechende Justageeinheit montiert, und seine Ausgangswelle ist über eine Kupplung 102 mit der Welle eines Bremsmotor 105 gekuppelt, der ebenfalls auf der Sockelplatte 106 befestigt ist. Der Bremsmotor 105 ist ebenso wie der Bremsmotor nach den Fig. 1 und 2 mit einem Positions- bzw. Winkelgeber 104 ausgestattet. Das Drehmoment zwischen dem Prüfmotor 101 und dem Bremsmotor 105 wird entweder durch einen Drehmomentgeber gemessen, der innerhalb der Kupplung 102 angeordnet ist, oder das Drehmoment wird durch den Strom des Bremsmotors 105 indirekt gemessen.

Zwischen dem Prüfmotor 101 und der Sockelplatte 106 sowie zwischen dem Bremsmotor 105 und der Sockelplatte 106 sind Kraftmeßdosen 106 bzw. 107 angeordnet, mit denen Kräfte in X-, Y- und Z-Richtung gemessen werden können. Auf diese Weise ist es möglich, nicht nur das Nutzdrehmoment in die Messungen bzw. in die Ermittlung optimaler Strom- bzw. Spannungskurven einzubringen, sondern auch etwaige Störkräfte am Prüfmotor 101 bzw. am Bremsmotor 105 in den entsprechenden anderen Richtungen. Um direkt am Rotor angreifende Kräfte zu messen, ist es angebracht, Kraftmeßdosen zwischen den Lagern des Rotors und dem Stator anzubringen.

Fig. 4 zeigt nun den mechanischen Aufbau eines Meß-und Prüfstandes für den Betrieb und/oder die Messung von mechanischen oder teilmechanischen Bauteilen. Solche mechanischen bzw. teilmechanischen Bauteile 109, z. B. eine Getriebe, müssen von außen her durch einen Hilfsantrieb angetrieben werden, was mittels eines Motorantriebes 108 über eine Kupplung 102a erfolgt. Auf der anderen Seite des mechanischen Bauteils 109 ist über eine weitere Kupplung 102b eine Motorbremse 105 angekuppelt, die gleichzeitig einen Positionsgeber 104 aufweist. Zum Messen der Drehmomente zwischen dem Motorantrieb 108 und dem mechanischen Bauelement 109 und zwischen diesem und der Motorbremse 105 sind Drehmomentaufnehmer angeordnet, die in die Kupplungen 102a and 102b integriert sein können.

Mit diesem Meß- und Prüfstand nach Fig. 4 können also die Daten des mechanischen Bauelementes (Getriebe) 109 gemessen werden, wobei das Drehmomentverhalten des Motorantriebes 108 bzw. der Motorbremse 105 natürlich möglichst gleichmäßig sein muß, um das Verhalten des mechanischen Bauteils 109 isoliert messen zu können.

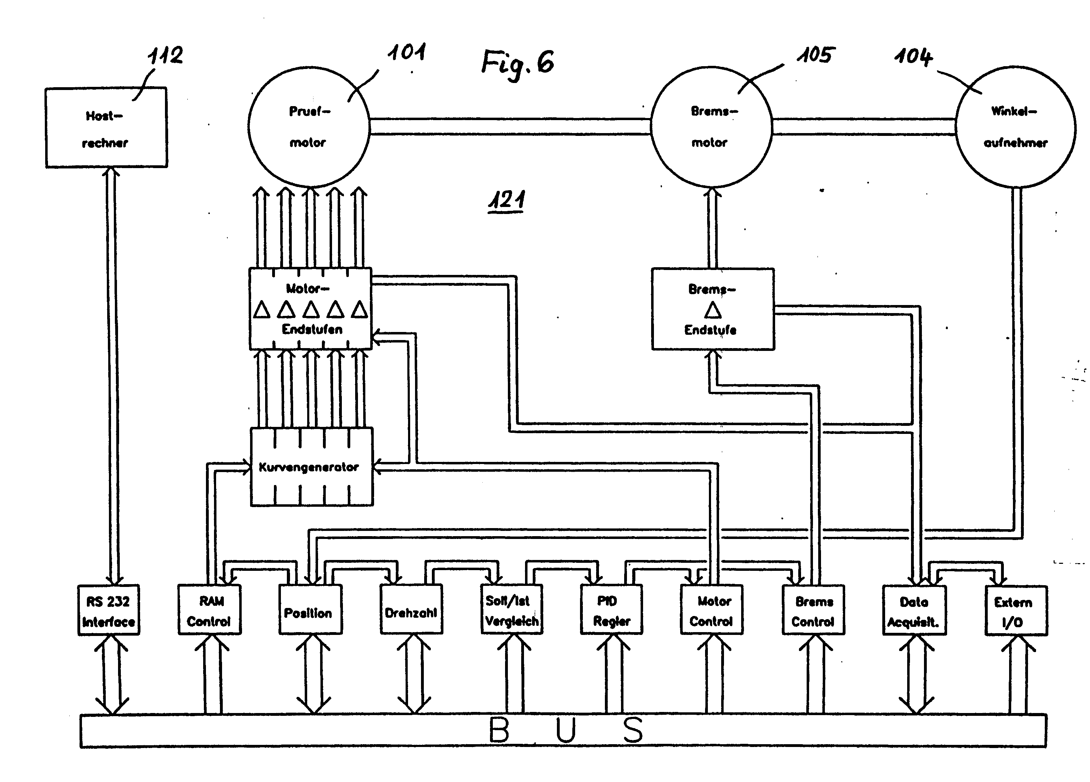

Das elektrische Gesamtsystem zur Messung und Prüfung von Elektromotoren gliedert sich in zwei Teilsysteme (s. Fig. 5), nämlich die Steuerung und Datenverarbeitung 110 sowie die Prüf- und Meßeinrichtung 120.

Das Teilsystem zur Steuerung und Datenverarbeitung 110 kann sich aus einem Hostrechner 112, sowie den peripheren Supportbausteinen Monitor 113, Tastatur 114, Harddisk 111 und Plotter (Option) zusammensetzen, wobei die angeführten Systeme aus externen Komponenten bestehen oder aber im Prüfstand selbst integriert sein können. Der Hostrechner 112 selbst übernimmt zweckmäßigerweise die Steuerung von den Prüf- und Meßabläufen, das Erfassen der Meßdaten und die Auswertungen. Zusätzliche Rechnereinheiten können ihn dabei unterstützen. Beispiele für den Aufbau der Software werden später beschrieben.

Das zweite Teilsystem 120 untergliedert sich in den Prüf- und Meßstand 121 sowie das Leistungsnetzteil 122 für die elektrische Versorgung von Prüf- und Bremsmotor. Zusätzliche Geräte können für den Betrieb herangezogen werden. So ist z. B. die Anschlußmöglichkeit von Oszillographen, Strommeßzangen, programmierbaren Multimetern und externen Signalgeneratoren über spezielle Input/Output-Kanäle realisierbar.

Mit dem Gesamtsystem ist ein automatischer Betrieb des Meß- und Prüfstandes möglich, wobei dem zu messenden elektromechanischen Wandler 101 über das Leistungsnetzteil 122 der Prüf- und Meßeinrichtung 120 Ströme bzw. Spannungen beliebig programmierbarer Kurvenformen eingeprägt werden können. Indirekt über die Vorgabe von Strom- oder Spannungsverläufen können auch andere physikalische Wandlergrößen eingeprägt werden, wie zum Beispiel Drehmomente, Kräfte, Drehzahlen, Beschleunigungen, magnetische Flüsse, Feldstärken, Induktionen, elektrische Feldstärken, Temperatur, etc. Je nach Art der Größe kann die Einprägung direkt über eine Steuerung erfolgen oder mit Hilfe eines Meßsensors durch eine Regelungsschaltung. Diese Kurvenformen ändern sich im Verlaufe der Zeit bzw. des durch den Positions- bzw. Drehwinkelgeber 104 vorgegebenen Wertes. Die einzelnen Meßwerte des elektromechanischen Wandlers 101 bzw. der Belastungs- oder Antriebseinheit 105 werden ermittelt, ausgewertet und gespeichert. Durch einen solchen automatischen Meß- und Prüfstand lassen sich z.B. Drehmomentschwankungen des Wandlers meßtechnisch erfassen und durch Optimierung der Kurvenform der eingeprägten Spannung bzw. des eingeprägten Stromes reduzieren. Sowohl die Messung als auch die Reduktion der permanentmagnetischen, der elektromagnetischen, der reluktanten und der mechanischen Drehmomentschwankungen können hierbei vollautomatisch über definiert eingeprägte Phasenströme erfolgen.

Ein Ausführungsbeispiel für den strukturellen Aufbau der Hardware-Schaltung eines Prüfstandes ist Fig. 6 zu entnehmen. Jedoch sind auch andere Konfigurationen möglich. Folgende Karten sind hier implementiert:
* RS 232 Interface
* RAM Control
* Kurvengenerator
* Prüfmotor Control
* Bremsmotor Control

* Positionsbestimmung
* Drehzahlbestimmung
* Soll-/Istwert Vergleich
* PID Regler (2)
* Data-Acquisition (2)
* Extern Input/Output
* Prüfmotor-Endstufen (5)
* Bremsmotor-Endstufe

Die Kommunikation des Hostrechners 112 mit dem Prüf-und Meßstand erfolgt über ein serielles RS 232 Interface, das direkt über den Systembus mit den einzelnen Karten einen bidirektionalen Datenverkehr unterhält. Die Übertragungsrate der Schnittstelle ist in Intervallen wählbar und beträgt maximal 19200 Baud.

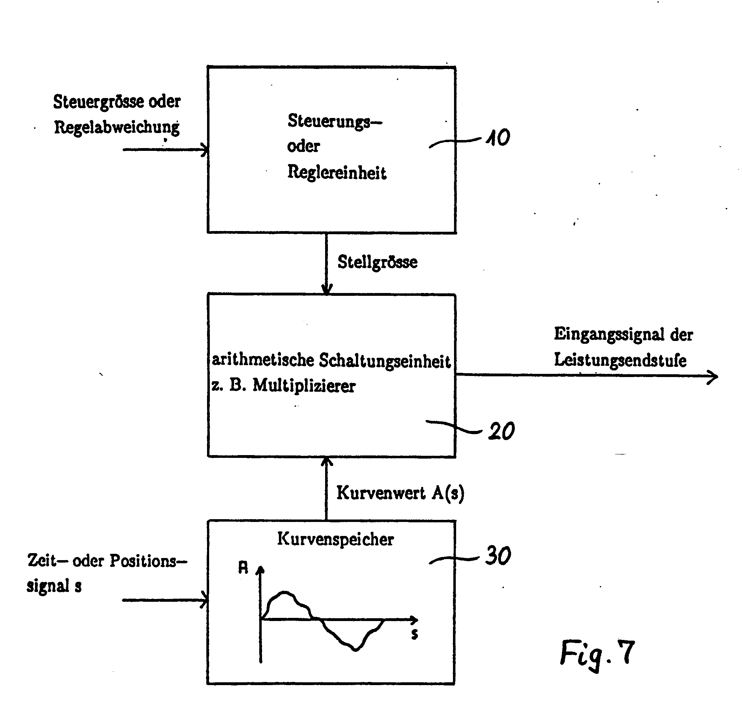

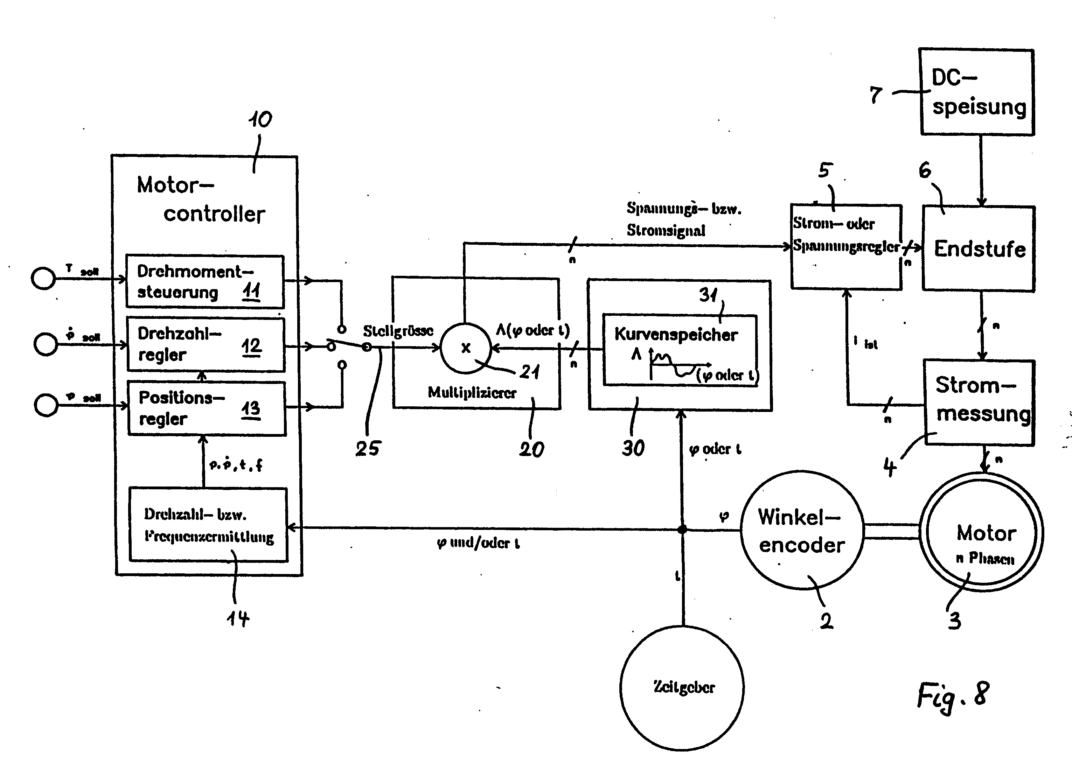

Nach dem Systemstart werden die normierten Kurvenformen der einzelnen Motorphasen in den Schreib-Lese-Speicher des Kurvengenerators geladen. Die RAM Control Karte übernimmt während des Ladevorganges und später auch während des Motorbetriebes die Datenorganisation. Prinzipiell sind die fünf Kurvengeneratoren nach dem Schaltungskonzept aus Fig. 7 aufgebaut. In Abhängigkeit von der aktuellen Position, der Zeit oder einer anderen Stellgröße, die im Prüfstand zur Verfügung steht, oder die extern eingespeist wird, erfolgt die Auslesung der gespeicherten Kurvenpunkte und anschließend deren Multiplikation mit der jeweiligen Steuer- oder Regelamplitude; das Ausgangsprodukt wird als Eingangssignal den entsprechenden Leistungsendstufen zugeführt und dort über Verstärkerstufen in Form von Strom- oder Spannungskurven den Motorphasen zur Verfügung gestellt. Ein mögliches Schaltbild einer kompletten Steuer- oder Regeleinrichtung ist in Fig. 8 dargestellt. Insgesamt sind mehrere Kurvenspeicher vorgesehen, zwischen denen auch bei laufendem Motor umgeschaltet werden kann.

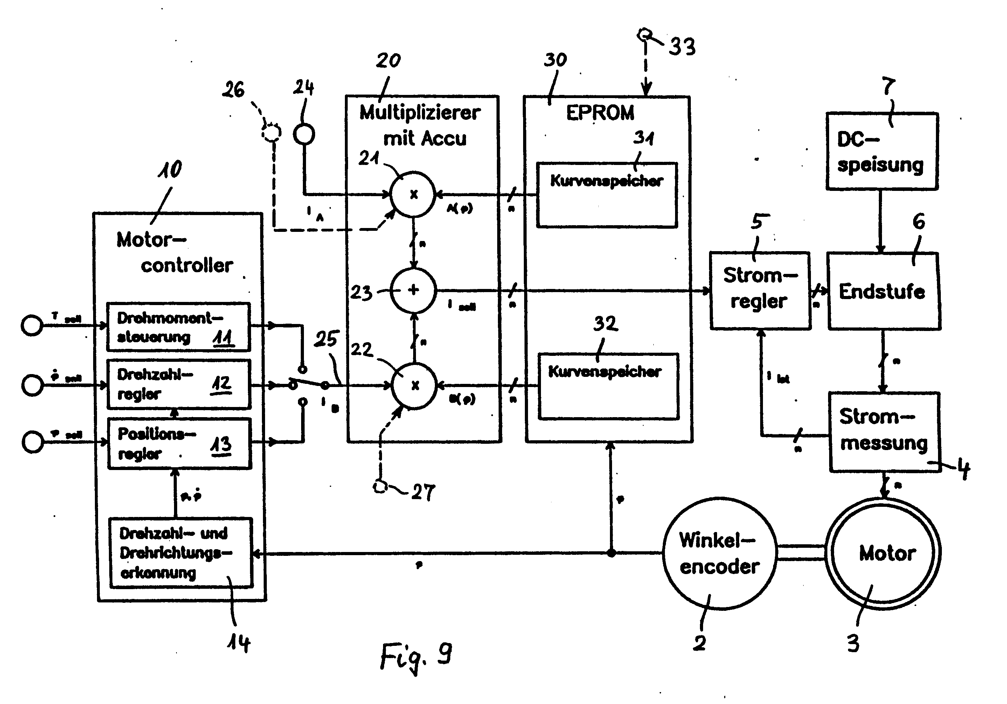

Anstelle der Lösung nach der Schaltungsanordnung nach Fig. 8 kann auch eine Schaltungsanordnung nach Fig. 9 verwendet werden, bei der mehrere Verknüpfungseinheiten und mehrere Datensätze in mehreren Funktionsspeicherabschnitten abgelegt sind, um mehrere Einflußgrößen zu berücksichtigen.

Anhand dieser Fig. 9 soll nun der Betrieb näher erläutert werden, wobei diese Beschreibung teilweise auch für die einfachere, ähnliche Schaltungsanordnung nach Fig. 8 gilt. Weitere Einzelheiten zu der Anordnung nach Fig. 9 sind einer Patentanmeldung mit dem Titel "Verfahren und Anordnung zur Ansteuerung elektromechanischer Wandler" (gleicher Erfinder, gleicher Anmelder, gleicher Anmeldetag) zu entnehmen.

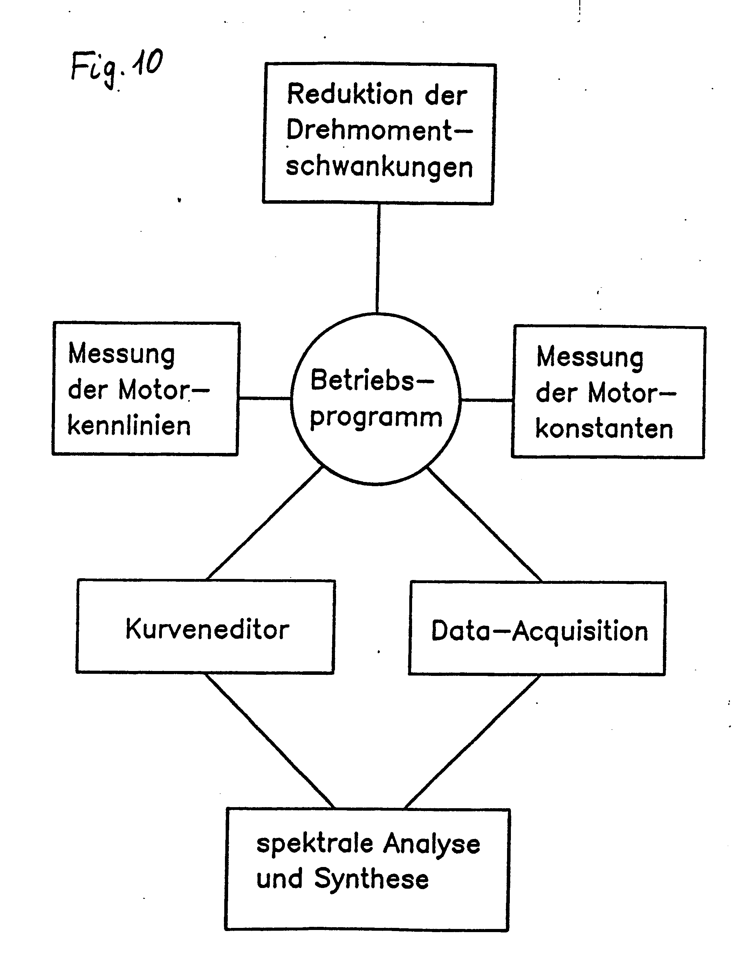

Fig. 9 zeigt in schematischer Darstellung eine Anordnung zur Ansteuerung elektromechanischer Wandler, im vorliegenden Fall eines Elektromotors. Die Schaltungsanordnung nach Fig. 9 enthält einen Motorcontroller 10, eine arithmetische Schaltungseinheit 20, einen Funktionsspeicher 30 sowie eine Leistungsversorgung für den Motor 3, die im vorliegenden Beispiel aus einem Stromregler 5, einer Endstufe 6, einer Gleichspannungsstromversorgung 7 und einer Strommeßvorrichtung 4 besteht. Die arithmetische Schaltungseinheit enthält zwei Multiplizierer 21 und 22 sowie eine Verknüpfungsschaltung in Form eines Akkumulators (Gummierer) 23, dessen Ausgangssignal den Stromregler 5 ansteuert. Der Funktionsspeicher 30 enthält im vorliegenden Fall zwei Kurvenspeicher 31 und 32, so daß zwei verschiedene Terme berücksichtigt werden können. Sollten noch weitere Terme, z. B. zur Kompensation von reluktanten oder in andere Richtungen als die Nutzkraft oder das Nutzdrehmoment wirkende Störeinflüsse, verarbeitet werden müssen, so sind die arithmetische Schaltungseinheit 20 und der Funktionsspeicher 30 noch um die entsprechenden Elemente zu erweitern. In einem solchem Fall erfolgen die Verknüpfungen möglicherweise nicht multiplikativ und additiv, wie in Fig. 10 gezeigt, sondern es sind entsprechende andere Verknüpfungen erforderlich.

Auch wenn in der Schaltungsanordnung nach Fig. 9 in dem Funktionsspeicher 30 pro Einflußgröße nur je ein Speicherabschnitt 31, 32 gezeigt sind, so kann jeder der Speicherabschnitte in mehrere Teile untergliedert sein, damit pro Einflußgröße verschiedene Datensätze gespeichert werden können. Diese verschiedenen Datensätze werden dann durch eine Eingangsgröße 33 ausgewählt.

Der Motorcontroller 10 enthält im vorliegenden Fall eine Drehmomentsteuerung 11, einen Drehzahlregler 12 und einen Positionsregler 13, deren Ausgangssignale über einen Umschalter wahlweise an einen Eingang 25 der arithmetischen Schaltungseinheit 20 gelegt werden, sowie eine Drehzahl- und Drehrichtungserkennung 14. Darüber hinaus ist noch ein Eingang 24 für die arithmetische Schaltungseinheit vorgesehen. Der Motor 3 ist mit einem Winkelencoder 2 gekuppelt, um sowohl für den Funktionsspeicher 30 als auch für den Motorcontroller 10 entsprechende Winkelpositionssignale zu liefern.

Stellvertretend für eine Vielzahl von Korrektur- oder Steuergliedern (Eingangsgrößen) ist der Eingang 26 oder 27 gezeichnet für eine mögliche Bewertung der Multiplikationsfaktoren 24 bzw. 25. Die Eingangsgröße 33 entscheidet über die Auswahl spezieller Kurven zur Berücksichtigung verschiedener Betriebszustände (nichtlinearer Betrieb aufgrund Eisensättigung und Ankerrückwirkung, Temperatur) und Motorbetriebsarten (z. B. gleichförmiger Betrieb oder pulsierender Betrieb als Schrittmotor).

Folgende Eingangsgrößen sind für die Schaltungsanordnung interessant: Stellgrößen für die Amplituden der gespeicherten Kurven oder des Kurvengenerators, gegebenenfalls eine Signalgröße, die das Auslesen der Kurven zeitabhängig oder in Abhängigkeit der Rotorstellung ermöglicht, Steuer- oder Signalgrößen zur Auswahl der Kurven und eventuell zur Veränderung der Kurvenform insbesondere bei nichtlinearer Motorcharakteristik, wo entsprechend dem Betriebszustand die Kurvenform anzupassen ist. Weiterhin können beispielsweise noch Steuergrößen für eine arithmetische Schaltungseinheit 20 auftreten, die den Ablauf der Verknüpfung von Stellgrößen und Kurven steuern oder die Verknüpfungsfunktion entsprechend dem Betriebszustand des Motors ändern. Als Ausgangsgrößen entstehen digitale, analoge oder sonstige Signalgrößen, die gegebenenfalls über einen Leistungssteller, definierte Ströme oder Spannungen den Motorphasen einprägen, um die Rundlaufgüte das Schwingungsverhalten sowie die Geräuscharmut des Motors zu verbessern.

Im Funktionsspeicher 30 sind die Daten für Kurven abgelegt, die zur Kompensation der einzelnen Drehmomentschwankungsarten führen. Die Daten können in Form von Tabellen, Vorschriften (z. B. Begrenzung der max. Stromamplitude), Gleichungen oder Funktionen abgespeichert werden. Je nach Symmetrie des magnetischen und elektrischen Kreises ist es nötig, die Kurven für alle Phasen getrennt oder nur je eine Kurve pro Drehmomentschwankungsart abzulegen. Im letzteren Fall werden die Kurven um den Phasenverschiebungswinkel versetzt ausgelesen. An die Stelle der Funktionsspeicher 30 können auch Kurven generatoren treten, die die definierten Kurven erzeugen.

Eine arithmetische Schaltungseinheit 20 verknüpft nun die zeit- oder rotorwinkelabhängig zur Verfügung gestellten Kurvenamplituden mit den Eingangsstellgrößen nach definierten Funktionen. Im vorliegenden Fall sind die Verknüpfungsglieder 21, 22 bzw. Addierglieder 23; für die Berücksichtigung anderer Einflußgrößen sind jedoch u. U. andere Verknüpfungen notwendig.

In der Schaltungsanordnung nach Fig. 9 werden die für eine Rotorumdrehung berechneten Stromkurvenwerte der einzelnen Phasen zur Reduktion der elektromagnetischen Drehmomentschwankung (Kurvenspeicher 32) und der permanentmagnetischen einschließlich der mechanischen Schwankung (Kurvenspeicher 31) getrennt und in normierter Form abgelegt.

Entsprechend dem Rotorwinkel $\phi$ wird die Stromkurve des Kurvenspeichers 31 ausgelesen und mit einer Stromamplitude $i_A$ (Eingang 24) multipliziert. Die Amplitude $i_A$ ist so gewählt, daß die permanentmagnetischen Drehmomentschwankungen minimal werden. Auch die Amplitude $i_A$ ist im abgespeicherten Datensatz enthalten. Bei Motoren mit ungesättigtem Eisenkreis und vernachlässigbarer Ankerrückwirkung kann die Amplitude konstant gehalten werden. Anderenfalls ist der Wert entsprechend den Gegebenheiten nachzuführen. Die auf diese Weise erzeugte Stromkurve fließt unverändert in die einzelnen Phasenwicklungen, unabhängig vom Betriebszustand des Motors und kompensiert somit die permanentmagnetisch und mechanisch verursachten Drehmomentpulsationen.

Unter der Voraussetzung, daß der Motor eine lineare Strom-Drehmomentcharakteristik besitzt, was bei permanentmagneterregten Motoren in der Regel gegeben ist, kann nun der Stromkurve

$$i_{permanent} = i_A A(\phi)$$

die eigentliche Betriebskurve additiv überlagert werden. Sie entsteht durch das Produkt aus der Regler-Stromamplitude mit der für die Kompensation der elektromagnetischen Drehmomentschwankungen bestimmten Stromkurve $B(\phi)$:

$$i_{el-magn} = i_B B(\phi)$$

Zeigt der betreffende Motor ein nichtlineares Verhalten, so ist es zweckmäßig, verschiedene Kurven pro Drehmomentschwankungsart für verschiedene Betriebsbereiche einzusetzen. Dies kann beispielsweise dadurch erfolgen, daß man abhängig vom Betriebszustand des Motors einen Kurvenauswahlschalter realisiert, der über einen Eingang 33 die entsprechenden Abschnitte der Speicherabschnitte 31, 32 usw. auswählt. Oder die Kurven werden geeignet verändert, so daß sie besser an den jeweiligen Betriebszustand angepaßt sind. Eine Anpassung kann aber auch über eine Veränderung der Eingangsstellgrößen 26, 27 erfolgen.

Für den Fall, daß die reluktanten Drehmomentschwankungen (oder noch andere Einflüsse) nicht vernachlässigbar sind, kann der Schaltung nach Fig. 9 noch ein dritter Pfad, bestehend aus einem zusätzlichen Speicherabschnitt und einem Verknüpfungsglied (nicht gezeigt) hinzugefügt werden, der die Reduktion der reluktanten Schwankungen durch entsprechende Stromverläufe erlaubt.

Nachfolgend sollen die restlichen Funktionsblöcke aus Fig. 6 erläutert werden:

Die Positionskarte wandelt die incrementalen Encodersignale, abhängig von der angewählten Encoderauflösung, in ein absolutes Winkelmaß um. Dieses wird direkt als Adresse an die RAM Control Karte weitergeleitet.

Gleichzeitig steht die aktuelle Position in der Drehzahlkarte an. Beispielsweise durch eine quarzgesteuerte Periodendauermessung und die anschliessende Kehrwertbildung über eine abgelegte Speichertabelle wird die aktuelle Drehzahl ermittelt. Die Dauer der Periodenmeßzeit ist in Intervallen wählbar.

Die Positions- und Drehzahlinformation liegt für die Weiterleitung an den Hostrechner am Systembus an und erreicht zusätzlich über den Soll-/Istwert Vergleicher den PID Regler. Dieser ist in analoger und digitaler Ausführung realisiert. Wahlweise erfolgt die Regelung des Prüfmotors oder der Bremse.

Der Betriebsmodus der beiden Motoren läßt sich über die Prüfmotor- und Bremsmotor-Controllerkarten einstellen. Folgende Parameter sind variierbar:
* Amplitudensteuerung
* Spannungs- bzw. Stromquelle
* Drehzahlsteuerung bzw. -regelung
* Strombegrenzung durch die Vorgabe von maximal zulässigen Amplituden oder durch die Vorgabe von maximal zulässigen integralen Strom-Zeit-Flächen
* Kurvenspeicher I bzw. II
* Ein- und Ausschalten der Endstufen

Die Endstufen eignen sich für den 4-Quadrantenbetrieb. Die Vorgabe der maximalen Stromzeitfläche erlaubt kurzzeitige Überströme, z. B. während des Anlaufens des Motors und begrenzt die Stromamplitude auf den zulässigen Dauerwert, sobald die definierte Stromzeitfläche überschritten ist.

Die Ausgänge der Endstufen werden von einer Data-Acquisition-Unit überwacht. So kontrolliert die Spannungen und Ströme aller Kanäle, inklusive der Ein- und Ausgänge der analogen Input/Output Karte und übermittelt die Meßkurven dem Hostrechner. Neben der A/D-Wandlung kann weiterhin eine Kanalumschaltung, sowie eine Meßbereichsumschaltung zur Anpassung an die jeweiligen Amplituden erfolgen.

Die externe I/O-Karte ist implementiert um in der Funktion als digitaler Speicheroszillograph von außen zugeführte Meßsignale aufzuzeichnen oder interne Signale nach der D/A-Wandlung an eine eventuelle äußere Meßperipherie weiterzuleiten.

Der Prüfstand verfügt weiterhin über eine Vorrichtung zur automatischen Kalibration der Meßeinrichtungen, insbesondere zur Fehlerkorrektur von Offset, Verstärkung oder Nichtlinearitäten.

Die Software des Meß- und Prüfstandes kann sehr umfangreich gestaltet werden. Eine mögliche Ausführung ist im folgenden dargestellt:

Die Struktur der Software ist hierarchisch aufgebaut. Sie untergliedert sich in folgende Programm-Pakete:
* Betriebsprogramm
* Kurveneditor
* Data-Acquisition-Unit
* spektrale Signalanalyse und -synthese
* Messung der Motorkonstanten
* Messung der Motorkennlinien
* Reduktion der Drehmomentschwankungen

Ein Beispiel für die strukturelle Verknüpfung ist Fig. 10 zu entnehmen.

Im Zentrum der Softwarestruktur steht das Betriebsprogramm, dessen Menüschaltplan in Fig. 11 dargestellt ist. Über Tasten (umrahmt) und Cursorfunktionen lassen sich die Input- und Outputvariablen (fett gedruckt) steuern.

Das Blockschema zeigt einen Motorreglerkreis, in den wahlweise der Prüfmotor oder die Bremse geschaltet werden kann. Sämtliche Glieder der Steuerungskette bzw. des Regelkreises lassen sich per Tastatur anwählen und näher spezifizieren:

Taste <O>

Definition des Offsetwinkels zwischen dem Encoder und der Kurvenform des Stromes oder der Spannung des Prüfmotors oder zwischen der Kurvenform und einem Zeitgeber.

Taste <Z>

Definition der Anzahl Incrementpulse über die eine Drehzahlmessung erfolgen soll.

Taste <A>

Definition des Incrementintervalls, nach dem eine neue Messung gestartet werden soll.

Taste <N>

Definition der Solldrehzahl als Reglereingangsgröße.

Taste <F>

Definition der Amplitude einer Rechteckfunktion, die der Solldrehzahl überlagert wird.

Taste <P>

Definition des Proportionalanteils der Reglerstufe.

Taste <I>

Definition des Integralanteils der Reglerstufe.

Taste <D>

Definition des Differentialanteils der Reglerstufe.

Taste <M>

Prüfmotorwahlschalter: Regelung - Steuerung.

Taste <S>

Definition der Amplitude der Steuergröße für den Prüfmotor (Einheit: Volt bzw. Ampere).

Taste <B>

Bremsmotorwahlschalter: Regelung - Steuerung

Taste <T>

Definition der Amplitude der Steuergröße für den Bremsmotor (Einheit: Volt bzw. Ampere).

Taste <K>

Wahlschalter für den Zugriff auf zwei freiprogrammierbare Kurvenspeicher A und B.

Taste <8>

Wahlschalter der Prüfmotoransteuerung: Spannungsquelle - Stromquelle

Taste <5>

Definition der kurzzeitig zulässigen maximalen Stromamplitude der Prüfmotorendstufen.

Taste <2>

Definition der maximalen Dauerstromamplitude der Prüfmotorendstufen.

Taste <.>

Wahlschalter für den Betriebszustand der Prüfmotorendstufen: Ein - Aus.

Taste <7>

Wahlschalter der Bremsmotoransteuerung: Spannungsquelle - Stromquelle.

Taste <4>

Definition der kurzzeitig zulässigen maximalen Stromamplitude der Bremsmotorendstufe.

Taste <1>

Definition der maximalen Dauerstromamplitude der Bremsmotorendstufe.

Taste <0>

Wahlschalter für Betriebszustand der Bremsmotorendstufe: Ein - Aus.

Nicht eingezeichnet ist der Wahlschalter zwischen Positions-, Drehzahl-, Momenten- oder Leistungsregelung.

Für die Eingabe von Spannungs- bzw. Stromkurven stehen im Editor zwei Varianten zur Auswahl:
* die punktweise Eingabe und
* die spektrale Eingabe der Kurven.

Die erste Variante eignet sich besonders für die Definition von Kurven, die sich durch wenige Polygonzüge darstellen oder approximieren lassen, wie beispielsweise Rechteck- oder Trapezfunktionen. Die übrigen Kurven werden vorteilsweise durch ihre spektralen Harmonischen spezifiziert. Die Beschreibungen hierzu erfolgen später.

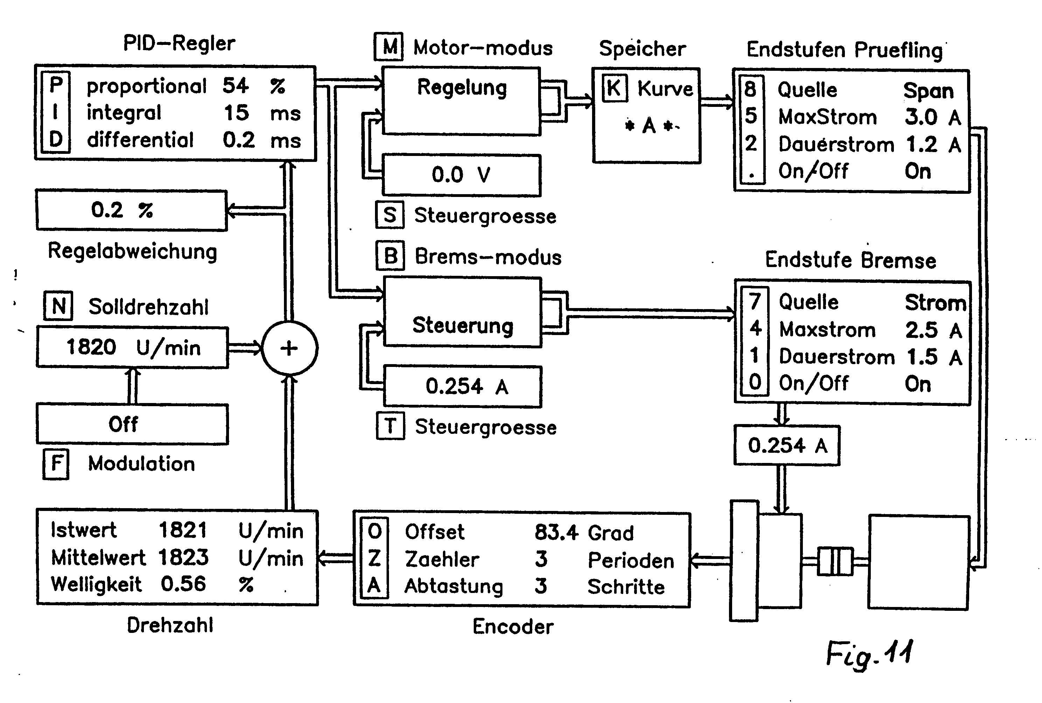

Die punktweise Aufzeichnung der Kurven erfolgt in normierter Form in Abhängigkeit vom Rotorwinkel $\phi$, der Zeit oder einer anderen Größe. Neben den eingegebenen Stützwerten der Kurven lassen sich z.B. durch Interpolation noch weitere Stützwerte berechnen. Fig. 12 zeigt ein Beispiel für eine zweipolige Ansteuerung. Um den Eingabevorgang zu erleichtern, steht dem Anwender ein Menü von mehreren Editierhilfen zur Verfügung, die in Stichworten kurz vorgestellt werden:
edit:
Auswahl der Motorphase;
Definition der zu editierenden Periode(n) bei mehrpoligen Systemen.
insert:
Einfügen eines neuen Kurvenpunktes.
delete:
Löschen eines Kurvenpunktes.
change:
Änderung der Amplitude eines Kurvenpunktes.
normalize:
Normalisierung der Kurve auf den Wert ±1.
shift-phase:
Phasenverschiebung der Kurve um einen Winkel $\phi$.
repeat:
Vervielfältigung einer editierten Periode auf den Winkelbereich von einer Rotorumdrehung.
copy:
Kopieren einer editierten Kurve auf alle Phasen mit entsprechender Phasenverschiebung.
draw:
Zeichnung der Kurve auf einem externen Plotter.
mark:
Markierung der editierten Kurvenstützpunkte.
transmit:
Übertragung der editierten Kurven vom Hostrechner auf den Prüfstand.
fft:
Sprung in das Programm für eine spektrale Fast-Fourier-Transformation. monitor:
Sprung in das Monitor-Programm mit der Data-Acquisition-Unit.
disc:
Zugriff auf einen externen Speicher für den Kurventransfer.
Untermenü: directory load save remove crunch quit
exit:
Ausstieg au dem Kurveneditor.

Die Data-Acquisition-Unit ist ein leistungsfähiges Software-Instrument zur schnellen Aufzeichnung (Mikrosekunden-Bereich) der aktuellen Motorgrößen. Die Meßgrößen können in Abhängigkeit einer beliebigen intern im Prüfstand verfügbaren oder extern eingespeisten Funktion aufgezeichnet und dargestellt werden. Der Hostrechner steuert und überwacht den Meßablauf, während die Messung selbst eigenständig vom Prüfstand ausgeführt wird. Aus der Sicht des Hostrechners gliedert sich der Meßvorgang unabhängig von der zu messenden Größe in vier aufeinanderfolgende Schritte:
* Initialisierung der Prüfstandsmeßeinheit;
* Start der Messung;
* Abruf der Meßwerte aus dem Zwischenspeicher des Prüfstandes;
* Auswertung der Meßdaten.

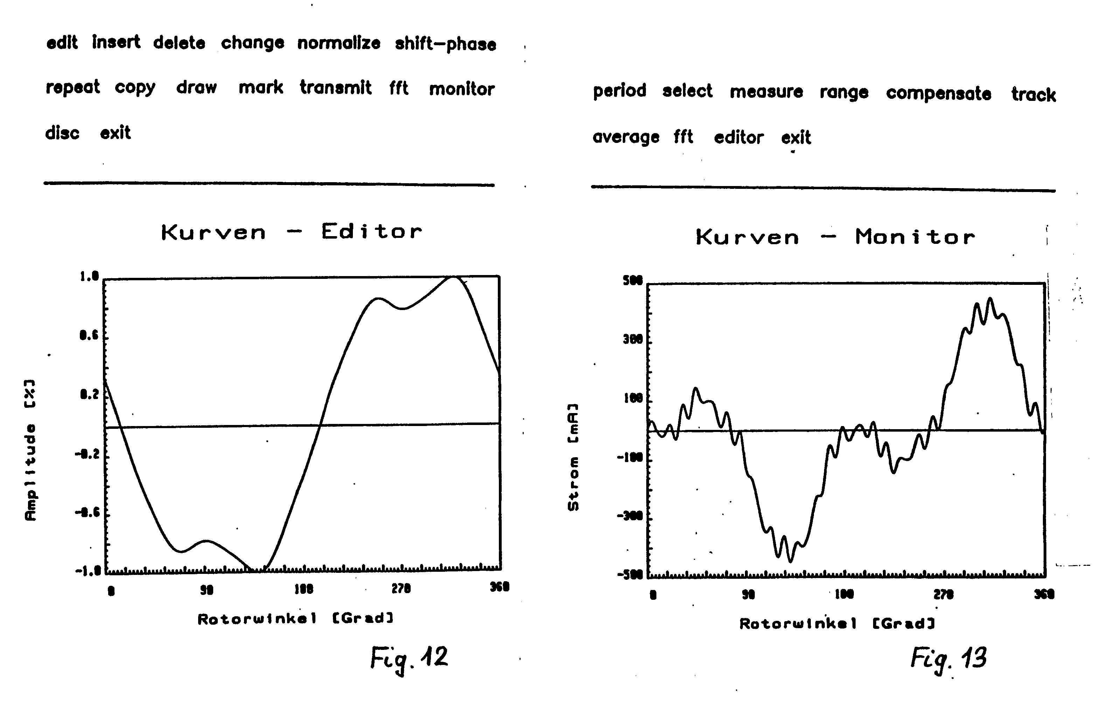

Für die Steuerung und Auswertung der Messung steht das Data-Acquisition-Menü aus Fig. 13 zur Verfügung. Die einzelnen Befehle werden in Stichworten kurz erläutert. period
Definition der darzustellenden Periode(n) bei mehrpoligen Systemen.
select
Untermenü:
measurement of
* electrical sizes
* mechanical sizes
Untermenü:
electrical sizes
* select channel:
brake - test-motor: phase 1..5 -external channels 1..2
* select measuring size:
voltage - current - power
Untermenü:
mechanical sizes
* select measuring size:
torque - speed

measure
Start der Messung.
range
Bereichswahl für die angewählte Meßgröße.
compensate
Automatische Offsetkompensation während der Messung.
track
Verschiebung des Cursors entlang der Meßkurve; Anzeige der Cursor-Koordinaten. average
Anzeige des Kurvenmittelwertes. fft
Sprung in das Programm für eine spektrale Fast-Fourier-Transformation.
editor
Sprung in das Editor-Programm.
edit
Ausstieg aus dem Data-Acquisition-Programm.

Die Kurven aus dem Editor bzw. aus der Data-Acquisition-Unit können mittels einer Fast-Fourier-Transformation oder einer anderen Funktionaltransformation in den Frequenzbereich überführt werden. Zur Analyse und zur Synthese im spektralen Bereich steht ein Editor zur Verfügung. Die harmonischen Komponenten lassen sich wählbar als Absolutwerte oder getrennt nach Real- und Imaginärteil darstellen. Editierte und gegebenenfalls auch in Amplitude und Winkel veränderte Harmonische oder deren Superposition lassen sich wieder in den Zeit- bzw. Winkelbereich zurücktransformieren. Die Bedienungsparameter des Editors werden für den 'absolute frequency-editor' (siehe Fig. 14) vorgestellt. insert
Einfügen einer neuen Harmonischen.
delete-single
Löschen einer Harmonischen
delete-range
Löschen mehrerer aufeinanderfolgender Harmonischen.
track
Verschiebung des Cursors entlang der Harmonischen mit Anzeige deren Kennwerte.
x-range
Bereichswahl der Harmonischen.
y-scale
Skalierung der Amplituden:
* lineare Darstellung,
* normierte Darstellung,
* logarithmische Darstellung.
list
Erstellen einer Liste der einzelnen Harmonischen wahlweise auf dem Bildschirm oder auf dem Drukker.
invers-fft
Rücktransformation in den Winkelbereich.
real-frequency-editor
Aufrug des Editors für die Darstellung des Realanteils.
imaginary-frequency-editor

Aufrug des Editors für die Darstellung des Imaginäranteils.
exit
Ausstieg aus dem Programm für spektrale Analyse und Synthese;
Die neu generierte Kurve kann wahlweise in eine der Kanäle des Editors oder der Data-Acquisition-Unit kopiert werden.

Die nachfolgend aufgeführten Motorkonstanten werden in vollautomatisch ablaufenden Meßprozeduren ermittelt. Eine Kurzbeschreibung des Menüplans gibt einen Überblick über die verfügbaren Funktionen.
calibration
Softwaremäßige Kalibrierung der Meßeinheit des Prüfstandes.
resistance
Messung des Phasenwiderstandes der Motoren über Strom- und Spannungsmessung.
inductance
Messung der Motorinduktivitäten über Strom- und Spannungsmessung.
torque-constant
Messung der Drehmomentkonstante $k_T$ für verschiedene Drehzahlbereiche.
friction
Messung des Reibungsmomentes in Abhängigkeit der Rotordrehzahl.
time-constant
Ermittlung der mechanischen Zeitkonstante über die Motorhochlaufkurve.
inertia
Ermittlung des Rotorträgheitsmoments über die Motorhochlaufkurve.
exit
Ausstieg aus dem Programm 'Messung der Motorkonstanten'.

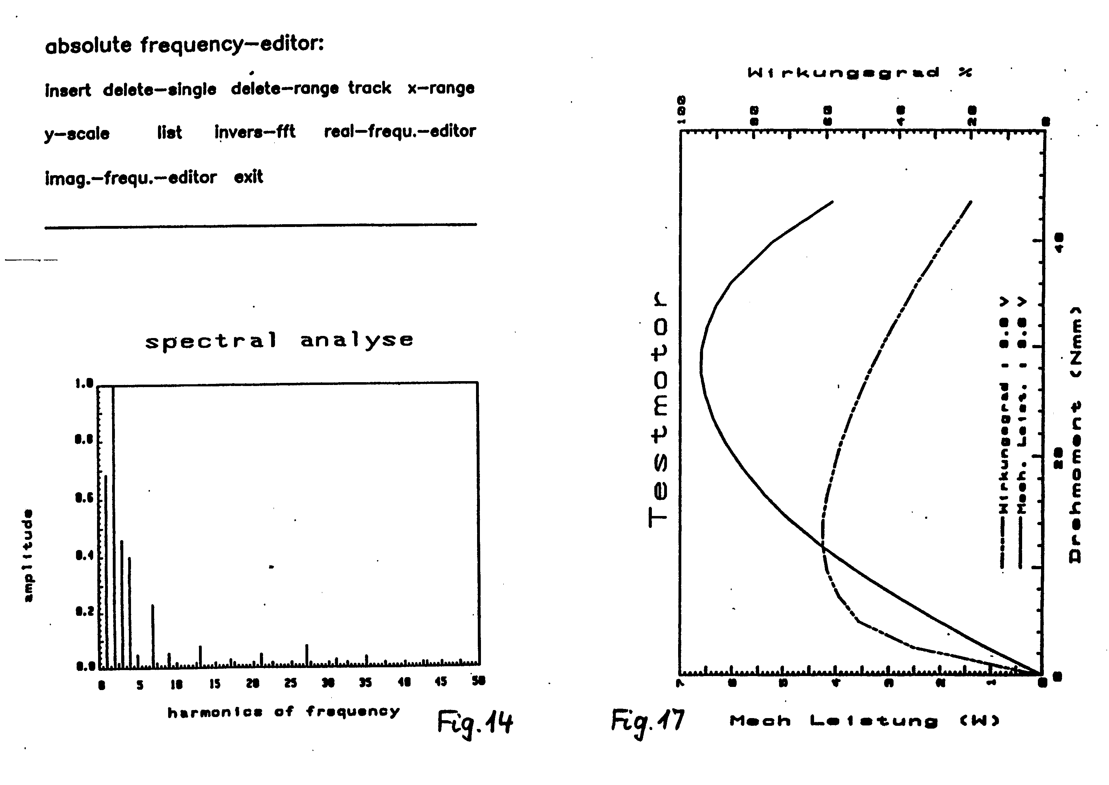

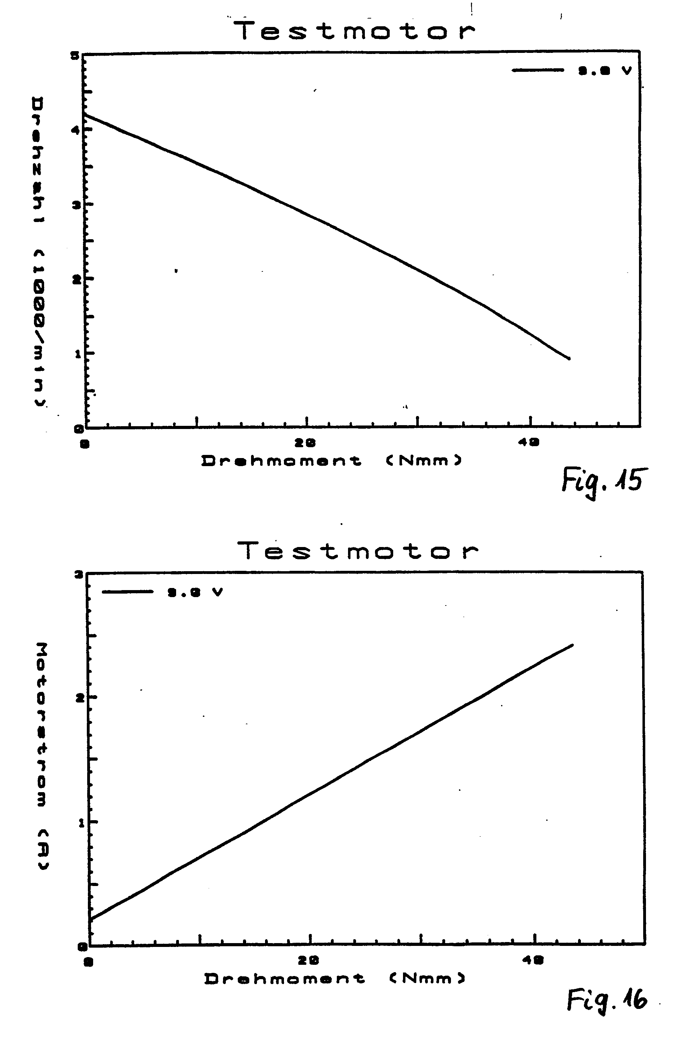

Die Messung der Motorkennlinien erfolgt durch vollautomatische Meßprozeduren. Für mehrere verschiedene Betriebsspannungen des Prüflings werden die Kennlinien als Funktion des Drehmomentes aufgenommen. Zu Beginn der Messung wird eine Kompensation der Bremsreibung durchgeführt, um anschließend die Kennlinien vom Leerlauf bis zum maximal zulässigen Bremsmoment punktweise zu ermitteln. Die graphische Darstellung der Messungen erfolgt wahlweise auf dem Bildschirm oder auf einem externen Plotter. In den Fig. 15 bis 17 sind Beispiele eines Testmotors zu sehen.

Wesentliche bisher realisierte Teile des Prüfstandes sind in folgender Zusammenfassung nochmals dargestellt. Insgesamt sind 3 Teilsysteme zu unterscheiden:

a) Prüfbanksystem mit Aktuatoren, insbesondere Brems- und/oder Antriebseinheiten, Meßwertaufnehmer, Wandler und sonstigen zur Prüfung oder Messung benötigte Elemente, sowie Montage-, Kupplungs-, Spann- und Justiervorrichtungen für diese Komponenten, sowie für den oder die Prüflinge.

b) Übergeordneter Hostrechner mit Peripheriegeräten, insbesondere Monitor, Tastatur, Speichermedium, Graphiktablett, Maus, Data-Acquisition-Unit, Joystick, etc., zur (Leit-)steuerung und/oder Datengenerierung und/oder -verarbeitung, insbesondere zur Steuerung der Prüf- und Meßabläufe, zur Definition der Prüf- und Meßvorschriften, zur Vorgabe der Betriebsparameter, insbesondere der einzuprägenden Größen, von Prüfling und Aktuator, zur Analyse, Auswertung, Verarbeitung, Transferierung, Komprimierung und Speicherung der Daten, sowie für die Eingabe und Editierung der Daten und Vorschriften (Schnittstelle Mensch - Prüfstand) und für die Fehlerkorrektur der Meßdaten, falls dies nicht vom nachfolgenden elektronischen Schaltungssystem bereits durchgeführt wird.

c) elektronisches Schaltungssystem, das auch ein (Multi-)Prozessorsystem sein kann, mit Steuer- und/oder Regelungs- und/oder (Leistungs-)Steller und/oder Energieversorgungseinheit(en) zur Ausführung der vom Hostrechner übermittelten Anweisungen und zur Einprägung der vorgegebenen Antriebs-, Erregungs-, Betriebs- oder Belastungsgrößen, wie Spannungen oder Ströme in vordefinierter Abhängigkeit prüfstandsinterner oder extern zugeführter Größen, sowie mit Vorrichtungen zur schnellen Meßwertaufnahme, -zwischenspeicherung und zur Kalibierung und Fehlerkorrektur der Meßeinrichtung und zum Schutz der angeschlossenen Komponenten vor Überlastung und Zerstörung.

## Ansprüche

1. Meß- und Prüfstand für mechanische, teilmechanische und elektromechanische Bauteile oder Baugruppen mit verschiedenen Meßeinrichtungen zum Messen verschiedener Parameter und mindestens einer einstellbaren Strom- oder Spannungsquelle zur Speisung mindestens eines zu prüfenden und/oder antreibenden elektromechanischen Wandlers,
gekennzeichnet durch
eine programmierbare Strom- und/oder Spannungsquelle zur Darstellung bzw. Einprägung beliebig definierbarer periodischer und/oder nichtperiodischer Kurvenformen elektrischer, magnetischer oder anderer physikalischer Größen für die Speisung des bzw. der Wandler,
eine Einrichtung zur Durchführung ron Meßläufen mit bestimmten, programmierbaren Kurvenformen der Strom-und/oder Spannungsquelle, und eine Einrichtung zum Auswerten bestimmter Parameter oder Kennlinien des Wandlers bei solchen Meßläufen und zum Abspeichern der dazugehörigen Meßwerte.

2. Meß- und Prüfstand nach Anspruch 1, für den Betrieb und/oder die Messung von elektromechanischen Wandlern, insbesondere Elektromotoren,
gekennzeichnet durch eine mit dem zu messenden Wandler gekuppelte, einstellbare Belastungs- oder Antriebseinheit.

3. Meß- und Prüfstand nach Anspruch 1, für den Betrieb und/oder die Messung von elektromechanischen Wandlern, insbesondere Elektromotoren,
gekennzeichnet durch einen Kraft- bzw. Drehmomentaufnehmer zwischen bzw. an dem Wandler und der Belastungs- oder Antriebseinheit.

4. Meß- und Prüfstand nach Anspruch 3,
dadurch gekennzeichnet, daß die Kraft bzw. das Drehmoment zwischen bzw. an dem Wandler und der Belastungs- oder Antriebseinheit mittels Strommessung in der Belastungs- oder Antriebseinheit ermittelt wird.

5. Meß- und Prüfstand nach Anspruch 1, für den Betrieb und/oder die Messung von elektromechanischen Wandlern, insbesondere Elektromotoren,
gekennzeichnet durch einen mit dem Wandler direkt oder indirekt gekuppelten Positions- bzw. Drehwinkelgeber.

6. Meß- und Prüfstand nach Anspruch 1, für den Betrieb und/oder die Messung von mechanischen oder teilmechanischen Bauteilen, die durch einen elektromechanischen Wandler, insbesondere Elektromotor, angetrieben werden,
gekennzeichnet durch eine mit dem zu messenden Wandler gekuppelte, einstellbare Belastungs- oder Antriebseinheit.

7. Meß- und Prüfstand nach Anspruch 1, für den Betrieb und/oder die Messung von mechanischen oder teilmechanischen Bauteilen, die durch einen elektromechanischen Wandler, insbesondere Elektromotor, angetrieben werden,
gekennzeichnet durch einen Kraft- bzw. Drehmomentaufnehmer zwischen bzw. an dem Wandler und der Belastungs- oder Antriebseinheit.

8. Meß- und Prüfstand nach Anspruch 7,
dadurch gekennzeichnet, daß die Kraft bzw. das Drehmoment zwischen bzw. an dem Wandler und der Belastungs- oder Antriebseinheit mittels Strommessung in der Belastungs- oder Antriebseinheit ermittelt wird.

9. Meß- und Prüfstand nach Anspruch 1, für den Betrieb und/oder die Messung von mechanischen oder teilmechanischen Bauteilen, die durch einen elektromechanischen Wandler, insbesondere Elektromotor, angetrieben werden,
gekennzeichnet durch einen mit dem Wandler direkt oder indirekt gekuppelten Positions- bzw. Drehwinkelgeber.

10. Meß- und Prüfstand nach einem oder mehreren der Ansprüche 1 bis 9,
dadurch gekennzeichnet, daß die Programmierung der Kurvenformen der Strom- bzw. Spannungsquelle durch spektrale Synthese und einer Überlagerung von einzelnen Harmonischen erfolgt.

11. Meß- und Prüfstand nach einem oder mehreren der Ansprüche 1 bis 9,
dadurch gekennzeichnet, daß die Programmierung der Kurvenformen durch Eingabe und Synthese von digital definierten Augenblickswerten erfolgt.

12. Meß- und Prüfstand nach einem der Ansprüche 1 bis 11,
dadurch gekennzeichnet, daß die Programmierung und Steuerung der Strom- und/oder Spannungsquelle in Abhängigkeit von der Zeit erfolgt.

13. Meß- und Prüfstand nach einem der Ansprüche 1 bis 11,
dadurch gekennzeichnet, daß die Programmierung und Steuerung der Strom- und/oder Spannungsquelle in Abhängigkeit vom Positions- bzw. Drehwinkelgeber erfolgt.

14. Meß- und Prüfstand nach einem der Ansprüche 1 bis 11,
dadurch gekennzeichnet, daß die Programmierung und Steuerung der Strom- und/oder Spannungsquelle in Abhängigkeit von einer internen oder externen Stellgröße erfolgt.

15. Meß- und Prüfstand nach einem der vorstehenden Ansprüche,
dadurch gekennzeichnet, daß eine Steuereinrichtung vorgesehen ist, die einen oder mehrere Meßläufe für einen oder mehrere Einflüsse (z. B. elektromagnetische, reluktante, permanentmagnetischen und mechanische Komponente) durchführt, in denen die vom Wandler ausgeübte Kraft bzw. das Drehmoment für einzelne Positionen bzw. Drehwinkel gemessen und aufgezeichnet werden,
daß eine Einrichtung vorgesehen ist, die manuell oder automatisch gesteuert die Optimierung der Kurvenform(en) der Strom- und/oder Spannungsquelle(n) für einen anzustrebenden Verlauf der ausgeübten Kraft bzw. des Drehmomentes nach frei definierbaren Optimierungskriterien vornimmt, und
daß die zu den einzelnen Positionen bzw. Drehwinkeln gehörenden Daten der Kurvenform(en) abgespeichert bzw. angezeigt werden.

16. Meß- und Prüfstand nach Anspruch 7,
gekennzeichnet durch eine Einrichtung, mit der die abgespeicherten Daten der ermittelten Kurvenformen, gegebenenfalls nach Durchführung von Interpolationen und/oder manueller oder rechnergesteuerter Korrektur, aufbereitet und in Form von Datensätzen für die Verwendung in Ansteuerschaltungen von elektromechanischen Wandlern ausgebbar sind.

17. Meß- und Prüfstand nach Anspruch 10 oder 11,
gekennzeichnet durch eine Einrichtung zum elektrischen Verschieben der programmierten und den Wandlern einzuprägenden Kurven bezüglich des Positions- bzw. Zeitmaßes.

18. Meß- und Prüfstand nach einem oder mehreren der vorstehenden Ansprüche,
dadurch gekennzeichnet, daß als Antriebs- oder Belastungseinheit ein Elektromotor vorgesehen ist, dessen eventuell nicht ideale Betriebscharakteristik elektronisch durch Einprägung von bestimmten Strom-bzw. Spannungskurven verbessert wird.

19. Meß- und Prüfstand nach einem oder mehreren der vorstehenden Ansprüche für rotierende elektromechanische Wandler,
dadurch gekennzeichnet, daß als Belastungs- oder Antriebseinheit ein Glockenankermotor vorgesehen ist, der gleichzeitig (über Strommessung) als Drehmomentaufnehmer dient bzw. ein definiertes Drehmoment einprägt.

20. Meß- und Prüfstand nach einem oder mehreren der vorstehenden Ansprüche für einen rotierenden Wandler,
dadurch gekennzeichnet, daß zusätzlich zu dem Nutz-Drehmomentaufnehmer Aufnehmer für andere Kraftvektoren oder Drehmomentkomponenten vorgesehen sind.

21. Meß- und Prüfstand nach einem oder mehreren der vorstehenden Ansprüche,
dadurch gekennzeichnet, daß die verschiedenen Steuer-, Auswert- und Speicherfunktionen durch einen mit der entsprechenden Software ausgestatteten Rechner durchgeführt werden.

22. Meß- und Prüfstand nach Anspruch 21,
gekennzeichnet durch einen oder mehrere Zwischenspeicher für Meßwerte, in denen diese zwischengespeichert werden, bevor sie in den Rechner transferiert und dort weiterverarbeitet werden.

Fig. 1

Fig. 2

Fig. 5

P234

Fig.3

Fig.4

P 234

**112**

**101** Fig.6 **105** **104**

Hostrechner

Pruefmotor

Bremsmotor

Winkelaufnehmer

**121**

Motor-
△ △ △ △ △
Endstufen

Brems-
△
Endstufe

Kurvengenerator

RS 232
Interface

RAM
Control

Position

Drehzahl

Soll/Ist
Vergleich

PID
Regler

Motor
Control

Brems
Control

Data
Acquisit.

Extern
I/O

B U S

EP 0 377 854 A1

Fig. 7

P234

**Fig. 8**

Fig. 9

Fig. 10

Reduktion der
Drehmoment—
schwankungen

Messung
der Motor—
kennlinien

Betriebsprogramm

Messung
der Motor—
konstanten

Kurveneditor

Data—Acquisition

spektrale Analyse
und Synthese

P234

## PID-Regler

| P | proportional | 54 | % |
| I | integral | 15 | ms |
| D | differential | 0.2 | ms |

M Motor-modus

**Regelung**

**0.0 V**

S Steuergroesse

**0.2 %**

Regelabweichung

B Brems-modus

N Solldrehzahl

**1820 U/min**

**Off**

F Modulation

( + )

**Steuerung**

**0.254 A**

T Steuergroesse

Speicher

K Kurve

* A *.

Endstufen Pruefling

| 8 | Quelle | Span |
| 5 | MaxStrom | 3.0 A |
| 2 | Dauerstrom | 1.2 A |
| . | On/Off | On |

Endstufe Bremse

| 7 | Quelle | Strom |
| 4 | Maxstrom | 2.5 A |
| 1 | Dauerstrom | 1.5 A |
| 0 | On/Off | On |

**0.254 A**

| Istwert | 1821 | U/min |
| Mittelwert | 1823 | U/min |
| Welligkeit | 0.56 | % |

Drehzahl

| O | Offset | 83.4 | Grad |
| Z | Zaehler | 3 | Perioden |
| A | Abtastung | 3 | Schritte |

Encoder

Fig.11

EP 0 377 854 A1

edit insert delete change normalize shift-phase
repeat copy draw mark transmit fft monitor
disc exit

period select measure range compensate track
average fft editor exit

## Kurven — Editor

Fig. 12

## Kurven — Monitor

Fig. 13

EP 0 377 854 A1

EP 0 377 854 A1

absolute frequency—editor:

insert  delete—single  delete—range  track  x—range

y—scale      list    invers—fft    real—frequ.—editor

imag.—frequ.—editor  exit

_____

spectral analyse

Fig.14

Wirkungsgrad %

Testmotor

Fig.17  Mech Leistung (W)

Testmotor

Fig. 15

Testmotor

Fig. 16

P234

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.5) |
|---|---|---|---|
| X | I.E.E.E. TRANSACTIONS ON POWER SYSTEMS, Band PWRS-2, Nr. 3, August 1987, Seiten 824-830; M.D. ANDESON et al.: "Computer-aided testing of electrical machines: software development" * Seiten 824,825; Absätze 3.6,4 * --- | 1,2,21, 22 | G 01 R 31/34 G 06 F 15/20 |
| Y | HEWLETT-PACKARD JOURNAL, Band 10, Nr. 12, August 1969, Seiten 2-6; R.A. GRIMM: "Automated testing" * Seiten 2,3,4, linke Spalte * --- | 1-3,14, 21,22 | |
| Y | CONFERENCE RECORD INDUSTRY APPLICATIONS SOCIETY IEEE-IAS-198 5, Annual Meeting, Twentieth Annual Meeting, Royal York Hotel, Toronto, CA, 6.-11. Oktober 1985, Seiten 742-747; F.H. WRIGHT: "Dynamic motor tests from synchronously sampled wave forms" * Bild 6, Seite 745, Absatz 1 * | 1-3,14, 21,22 | |
| A | IDEM --- | 6,7,16 | RECHERCHIERTE SACHGEBIETE (Int. Cl.5) |
| A | DE-A-1 954 089 (SIEMENS A.G.) * Patentanspruch 1 * --- | 4,8 | G 01 R G 06 F |
| A | DE-A-2 420 166 (SIEMENS A.G.) * Seite 4, Zeilen 22-23 * --- | 5,9 | |
| A | US-A-4 205 383 (E.A. BAKANOVICH et al.) * Spalte 1, Zeilen 63-66 * --- | 10 | |
| A | MESSEN, PRÜFEN, AUTOMATISIEREN, Nr. 3, März 1988, Seiten 103-105; J. KLEIN: "Test Management - neue Methoden in Messdatenerfassung und -Auswertung --- -/- | 11,12 | |

Der vorliegende Recherchenbericht wurde für alle Patentansprüche erstellt

| Recherchenort | Abschlußdatum der Recherche | Prüfer |
|---|---|---|
| DEN HAAG | 02-04-1990 | LUT K. |

**Europäisches Patentamt**

## EUROPÄISCHER RECHERCHENBERICHT

### EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.5) |
|-----------|-------------------------------------------------------------------------------------|-------------------|------------------------------------------|
| A | AU-B- 49 251 (AUSTRALIAN TELECOMMUNICATIONS COMMISSION)(1985) * Seite 7, Zeile 21 - Seite 8, Zeile 7 * | 15,18 | |

RECHERCHIERTE SACHGEBIETE (Int. Cl.5)

Der vorliegende Recherchenbericht wurde für alle Patentansprüche erstellt

| Recherchenort | Abschlußdatum der Recherche | Prüfer |
|---------------|-----------------------------|--------|
| DEN HAAG | 02-04-1990 | LUT K. |

KATEGORIE DER GENANNTEN DOKUMENTE

X : von besonderer Bedeutung allein betrachtet
Y : von besonderer Bedeutung in Verbindung mit einer anderen Veröffentlichung derselben Kategorie
A : technologischer Hintergrund
O : nichtschriftliche Offenbarung
P : Zwischenliteratur

T : der Erfindung zugrunde liegende Theorien oder Grundsätze
E : älteres Patentdokument, das jedoch erst am oder nach dem Anmeldedatum veröffentlicht worden ist
D : in der Anmeldung angeführtes Dokument
L : aus andern Gründen angeführtes Dokument

......................................................................
& : Mitglied der gleichen Patentfamilie, übereinstimmendes Dokument

EPO FORM 1503 03.82 (P0403)